# EUROPEAN PATENT APPLICATION

(11) **EP 3 322 082 A1**
(43) Date of publication of application: **16.05.2018**
(21) Application number: 15898229.8
(22) Date of filing: 10.07.2015
(51) Int. Cl.: H02M 7/48

(54) **ELECTRIC POWER CONVERSION DEVICE AND TEMPERATURE REDUCTION METHOD FOR SAME**

(71) Applicant: Hitachi Industrial Equipment Systems Co., Ltd., Chiyoda-ku Tokyo 101-0022 (JP)
(72) Inventor: TANABE, Keisuke, Tokyo 101-0022 (JP); ARAO, Yusuke, Tokyo 101-0022 (JP); EJIMA, Shingo, Tokyo 101-0022 (JP)
(74) Representative: Strehl Schübel-Hopf & Partner
(86) International application number: PCT/JP2015/069966
(87) International publication number: WO 2017/009913

(57) **Abstract**

In order to achieve the purpose of providing an electric power conversion device that can adapt a temperature reduction method of an electric power conversion device to a user's environment, the present invention provides a temperature reduction method for an electric power conversion device, wherein priority levels are set for implementing fallback control in a plurality of temperature control elements, and if the temperature of the electric power conversion device becomes higher than a temperature-abnormality determination value, fallback control is implemented in the temperature control element having the highest priority level according to the set priority levels, and if the control amount of the temperature control element having the highest priority level reaches a maximum value, while maintaining the control amount of the control element at the maximum value, fallback control is implemented in the temperature control element having the next highest priority level.

## Description

### TECHNICAL FIELD

The present invention relates to an electric power conversion device, and more particularly, a temperature reduction method thereof.

### BACKGROUND ART

A background art of the present technical field is disclosed in JP 9-121595 A (Patent Document 1). In Patent Document 1, "To achieve temperature protection without lowering torque even when a temperature of a switching element of a main inverter circuit becomes high" is stated as PROBLEM, and "A limit torque command τL is obtained by restricting a torque command τ using a torque limit value, a three-phase control voltage command V is obtained from the limit torque command τL, and a modulation command P is obtained by performing PWM using the three-phase control voltage command V and a carrier signal CH or CL. An equivalent three-phase current I is obtained by tuning on or off a switching element of the main inverter circuit 4 in accordance with the modulation command P and transferred to a motor 6. If a detected temperature T of the switching element increases, switching from a high frequency carrier CH to a low frequency carrier signal CL is first performed, and if the temperature increases nonetheless, the limit torque command τL is decreased by decreasing the torque limit value." is stated as SOLUTION.

### CITATION LIST

### PATENT DOCUMENT

Patent Document 1: JP 9-121595 A

### SUMMARY OF THE INVENTION

### PROBLEMS TO BE SOLVED BY THE INVENTION

In the technique disclosed in the above Patent Document, a series of conditions that when a reference temperature is exceeded, the carrier frequency is preferentially decreased, and when the temperature increases nonetheless, the torque limit value is decreased are stated, and an execution order of control elements which are temperature reduction or protection targets is fixed. However, this method is unable to cope with it is not desired to decrease the carrier frequency. If the carrier frequency is decreased, there is an effect of reducing a loss, but there is a problem in that a noise is increased, it is not allowed depending on devices or environments in which quietness is emphasized, and it is not a temperature control element which is desired to be necessarily preferentially decreased. Further, in a general control method for temperature protection, a temperature control element such as a method of controlling an air flow of a cooling fan, for example, in accordance with a detected temperature and perform heat dissipation or a method of performing temperature protection by decreasing a current limit value of an inverter to a predetermined value larger than zero, for example, in accordance with a detected temperature is used. However, in each single method, the temperature reduction of the electric power conversion device may be insufficient. Also, if a plurality of methods are executed at the same time, a function restriction may be excessively performed, and a function having a high priority in a system of each user may be disturbed.

In this regard, in order to solve the above problems, the present invention provides an electric power conversion device which is capable of adapting a temperature control element which is an individual method to an environment of the user.

### SOLUTIONS TO PROBLEMS

In order to solve the above problem, the present invention employs, for example, configurations set forth in claims. The present application includes a plurality of constituent elements for solving the above-mentioned problem, and as an example, a temperature reduction method of an electric power conversion device includes setting a priority for performing fallback control on a plurality of temperature control elements, executing the fallback control on a temperature control element having a highest priority in accordance with the set priority when a temperature of the electric power conversion device is higher than a temperature abnormality determination value, and executing the fallback control on a temperature control element having a second highest priority while holding a control amount of the temperature control element having the highest priority to a maximum value when the control amount of the control element reaches a maximum value.

### EFFECTS OF THE INVENTION

According to the present invention, it is possible to provide a method of sustaining a function of a user system as much as possible by effectively controlling a temperature control element which affects a loss.

### BRIEF DESCRIPTION OF THE DRAWINGS

Fig. 1 is a system configuration diagram of an electric power conversion device and an AC motor according to a first embodiment.
Fig. 2 is a diagram illustrating a priority setting example of a temperature control element according to the first embodiment.
Fig. 3 is a flowchart of fallback control at the time of temperature abnormality according to the first embodiment.
Fig. 4 is a time chart of fallback control when a temperature abnormality is detected according to the first embodiment.
Fig. 5 is a time chart of fallback control when a temperature abnormality is released according to the first embodiment.
Fig. 6 illustrates a priority input setting screen of fallback control of a temperature control element in a manipulating unit of an electric power conversion device according to a second embodiment.
Fig. 7 illustrates a fallback control-control amount maximum value setting screen as a setting of a temperature control element in a manipulating unit of an electric power conversion device according to the second embodiment.
Fig. 8 illustrates an input setting screen for whether or not error protection is performed at the time of temperature abnormality in a manipulating unit of an electric power conversion device according to a third embodiment.

### MODE FOR CARRYING OUT THE INVENTION

Hereinafter, embodiments of the present invention will be described with reference to the appended drawings.

### First embodiment

In the present embodiment, an operation example of a system into which an electric power conversion device 100 is incorporated.

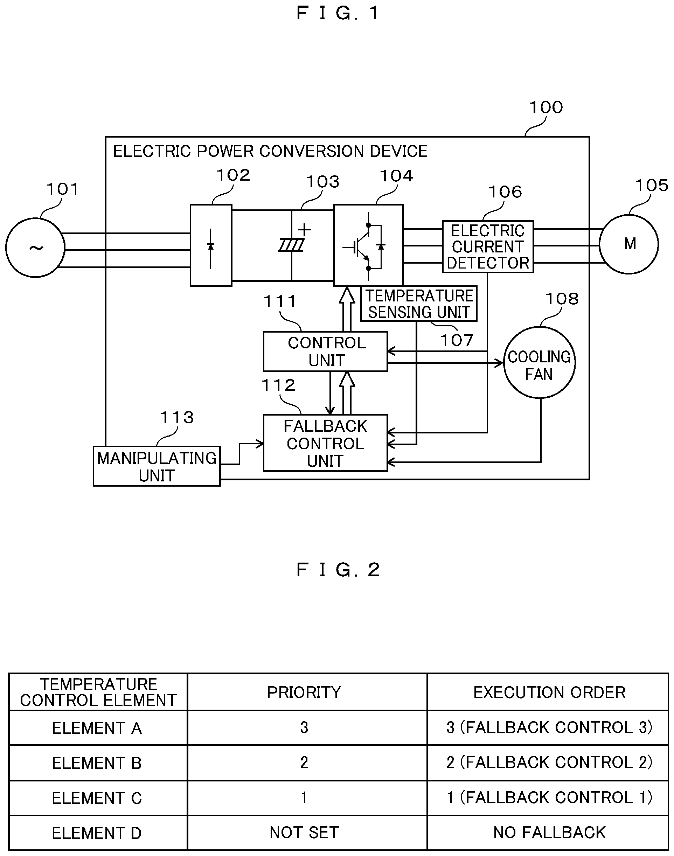

Fig. 1 is a system configuration diagram of the electric power conversion device 100 and an alternating current (AC) motor 105 in the present embodiment. Fig. 1, the electric power conversion device 100 includes a direct current (DC) converting unit 102, a DC smoothing unit 103, an AC converting unit 104, a current detecting unit 106, a temperature detecting unit 107, a cooling fan 108, a control unit 111, a fallback control unit 112, and a manipulating unit 113. A signal line between components is actually more complicated than illustrated, but for the sake of simplicity, a signal line is illustrated only in a part related to the present embodiment, and other parts are omitted.

A three-phase AC power source 101 outputs, for example, a three-phase AC voltage supplied from an electric power company or an AC voltage supplied from a generator to the DC converting unit 102.

For example, the DC converting unit 102 is configured with a DC conversion circuit including a diode or a DC conversion circuit using an IGBT and a flywheel diode, and converts the AC voltage input from the three-phase AC power source 101 into a DC voltage and outputs the DC voltage to the smoothing capacitor 103. In Fig. 1, the DC converting unit including a diode is illustrated.

The smoothing capacitor 103 smooths the DC voltage input from the DC converting unit 102 and outputs the DC voltage to the AC converting unit 104. For example, when an output of the generator is a DC voltage, the smoothing capacitor 103 may receive the DC voltage directly from the generator without intervention of the DC converting unit 102.

For example, the AC converting unit 104 includes is configured with an AC conversion circuit using an IGBT and a flywheel diode, and receives the DC voltage of the smoothing capacitor 103 and a PWM command of the control unit 111, converts the DC voltage into an AC voltage, and output the AC voltage to the AC motor 105.

The current detecting unit 106 detects an electric current flowing to the AC motor 105 and outputs detected electric current information to the control unit 111 and the fallback control unit 112.

For The temperature detecting unit 107 detects, for example, a temperature of a semiconductor element such as an IGBT or a diode, and outputs a temperature signal to the fallback control unit 112.

The cooling fan 108 receives a drive voltage from the control unit 111 and outputs revolutions information to the fallback control unit 112.

The control unit 111 receives the electric current information from the current detecting unit 106, a temperature control element serving as a fallback control target from the fallback control unit 112, and a control amount of the temperature control element, outputs the PWM command to the AC converting unit 104, and outputs the drive voltage to the cooling fan 108.

The fallback control unit 112 receives the electric current information of the current detecting unit 106, the temperature signal of the temperature detecting unit 107, the revolutions information from the cooling fan 108, the carrier frequency from the control unit 111, the frequency to be output to the AC motor 105, the priority of the temperature control element output from the manipulating unit 113, a maximum value of a control amount, and a selection setting of a degeneracy control of each temperature control element, and outputs the temperature control element serving as the fallback control target and the control amount of the temperature control element to the control unit 111. The fallback refers to an operation performed in a safe state in which performance is lowered. Further, the setting to the fallback control unit 112 may be performed, for example, by communication with a PC connected to the electric power conversion device.

The manipulating unit 113 is, for example, a manipulation panel mounted on the electric power conversion device 100, and outputs the priority of the temperature control element of the fallback control and the maximum value or the selection setting of the control amount of the temperature control element to the fallback control unit 112. The manipulating unit 113 may be a programmable logic controller (PLC) or an external device such as a PC or a tablet.

Fig. 2 illustrates a priority setting example when there are, for example, three temperature control elements. In the present embodiment, the user sets a priority of a large numerical value to a temperature control element having a high degree of demand of the user, that is, a temperature control element which is desired to be operated to the end. As a method of assigning a priority, for example, a priority of a large numerical value may be set to an element having a low degree of demand of the user. Further, a plurality of elements having the same priority may be set, and fallback control of a plurality of temperature control elements may be executed in parallel. Further, if the user does not desire to perform the fallback control, the priority is not set so that the fallback control is not executed.

As illustrated in Fig. 2, in the present embodiment, when a temperature abnormality is detected, the fallback control unit 112 executes the fallback control on each temperature control element in the order of an element C, an element B, and an element A. As the execution order, the elements C, B, and A are set as fallback control 1, 2, and 3, respectively. In the present embodiment, the description will proceed under the assumption that the element C is a carrier frequency, the element B is cooling fan revolutions, and the element A is an output frequency. Further, in the present embodiment, as illustrated in Fig. 2, the element D is set so that the fallback control is not executed and constantly continuously performed in accordance with an operation set by the user. For example, when the element D is a limit value of an output current value, since the fallback control is not executed, the element D is constantly continuously performed in accordance with the limit value of the output current value set by the user.

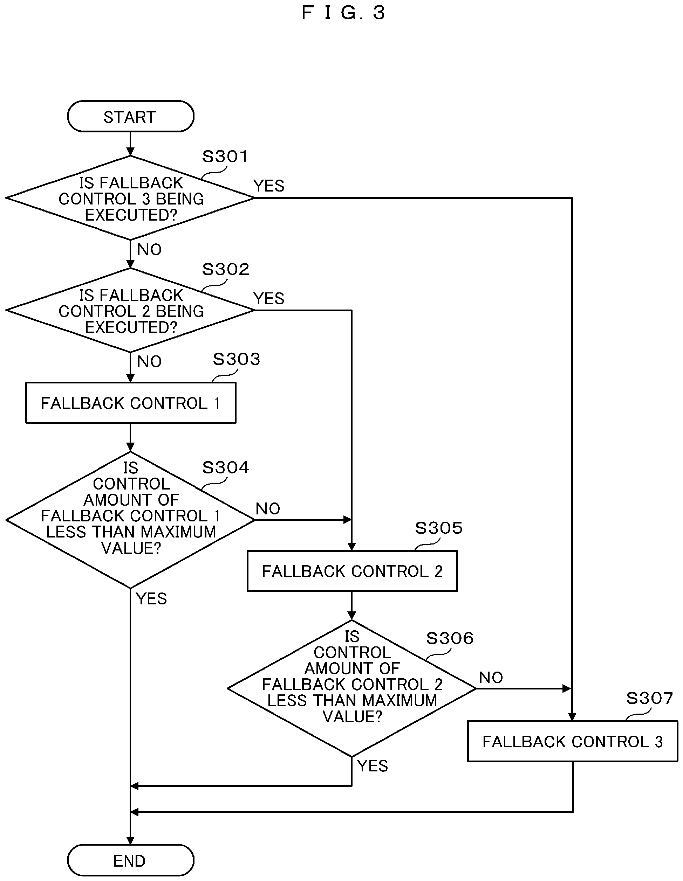

Fig. 3 illustrates an example of a flowchart in a case in which a temperature abnormality is detected when the fallback control unit 112 executes the fallback control with the three temperature control elements set in Fig. 2.

The fallback control unit 112 does not execute any fallback control before the temperature abnormality is detected, and when the temperature abnormality is detected, the fallback control 3, that is, the element A is not yet executed (S301), and the fallback control 2 is also not executed (S302), and thus the fallback control 1, that is, the carrier frequency control set as the element C is executed (S303). For example, when the carrier frequency is set to 15 kHz, the fallback control unit 112 starts decreasing the carrier frequency. If the temperature abnormality is not released, for example, the fallback control unit 112 reduces the carrier frequency, for example, up to 5 kHz of a maximum control amount set as a limit value at which sensitivity is high as an audible range by the user.

The fallback control unit 112 determines that the carrier frequency control amount of the fallback control 1 is not the maximum value (S304). When the carrier frequency control amount is not the maximum value, the fallback control unit 112 ends the flow chart, checks the status of each fallback control again from the beginning, and then continues the carrier frequency control.

When the carrier frequency control amount is the maximum value, the fallback control unit 112 executes revolution control of a fan set as the fallback control 2, that is, the element B as a second step (S305). For example, when the number of revolutions of the cooling fan is controlled at 3000 rpm, the fallback control unit 112 starts to increase the number of revolutions of the cooling fan. When the temperature abnormality is not released, the fallback control unit 112 increases the number of revolutions, for example, up to 4000 rpm of a maximum control amount in which a decrease in lifetime or an increase in nose is set as a limit value.

The fallback control unit 112 determines that the revolution control amount of the cooling fan of the fallback control 2 is not the maximum value (S306). When the revolution control amount of the cooling fan is not the maximum value, the fallback control unit 112 ends the flowchart, checks the status of each fallback control again from the beginning, then determines that the revolution control of the cooling fan is being executed in S302, and executes the fallback control 2, that is, the revolution control of the fan while executing the carrier frequency control (S305).

When the revolution control amount of the fan is the maximum value, the fallback control unit 112 executes the output frequency control set as the fallback control 3, that is, the element A as a third step (S307). For example, when the output frequency to the AC motor is controlled at 40 Hz, the fallback control unit 112 starts to decrease the output frequency. When the temperature abnormality is not eliminated, the fallback control unit 112 decreases the output frequency, for example, up to 10 Hz of the maximum control amount which is the limit value set by a value in which a decrease in the number of revolutions is allowed.

Fig. 3 illustrates an aspect of controlling a maximum of three temperature control elements, but even when the number of temperature control elements increases, the temperature control effect can be further obtained by controlling the temperature control elements sequentially. Further, it is set by the user in advance whether the fallback control unit 112 causes the electric power conversion device 100 to continue the operation as long as possible in a state in which the control amounts of all the temperature control elements are held to the maximum value or performs a process of outputting an error as a temperature control range abnormality and performing the protection operation, for example, shutting off the operation in order to prevent the damages of the electric power conversion device 100 when the fallback control 3 has the maximum value.

Further, the fallback control unit 112 gives a notification indicating that the fallback is being performed to the user, for example, through a display panel serving as the operation unit or a signal output during the fallback.

Further, for example, when the temperature control element is the carrier frequency, the control of decreasing the carrier frequency is performed as the control of decreasing the temperature, and the maximum value of the control amount is, for example, a preset value such as a lower limit value of the carrier frequency set due to technical reasons, for example, a lower limit value of the carrier frequency set by a client using the manipulating unit 113 due to reasons such as noise, and the maximum value of the control amount is a lower limit in terms of a value but a maximum value in terms of a control amount. Further, the maximum value of the control amount may be used as a maximum value of a range in which the control amount changes. Further, the maximum value of the control amount may be used as a setting value of the control amount change range.

The abnormality in the temperature change includes a change width or a change cycle of a temperature in the absolute value of the temperature. Further, the temperature control element may be controlled such that the temperature decreases, the change width of the temperature decreases, or the change cycle of the temperature increases.

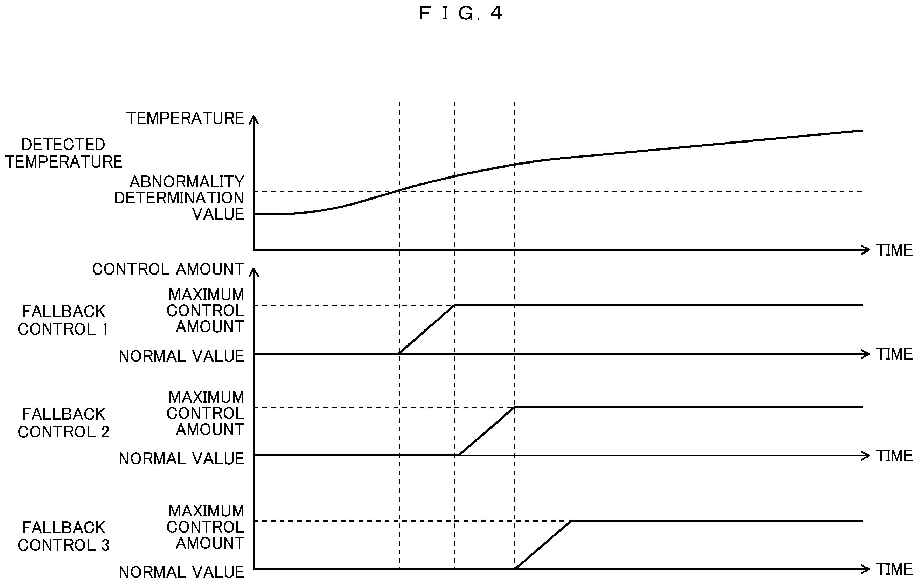

Fig. 4 is a time chart in a case in which the fallback is performed in accordance with the flowchart of Fig. 3 when the temperature detected by the temperature detecting unit 107 exceeds a temperature abnormality determination value, and a temperature abnormality is detected. In Fig. 4, when an abnormality in the temperature from the temperature detecting unit 107 is detected, the fallback control unit 112 executes the fallback control 1 on the element C having the highest priority, and when the control amount of the fallback control 1 reaches the maximum value, the fallback control unit 112 executes the fallback control 2 in a status in which the control amount of the element C is held to the maximum value. Further, when the control amount of the element B of the fallback control 2 reaches the maximum value, the fallback control unit 112 executes the fallback control 3 on the element A through a similar procedure.

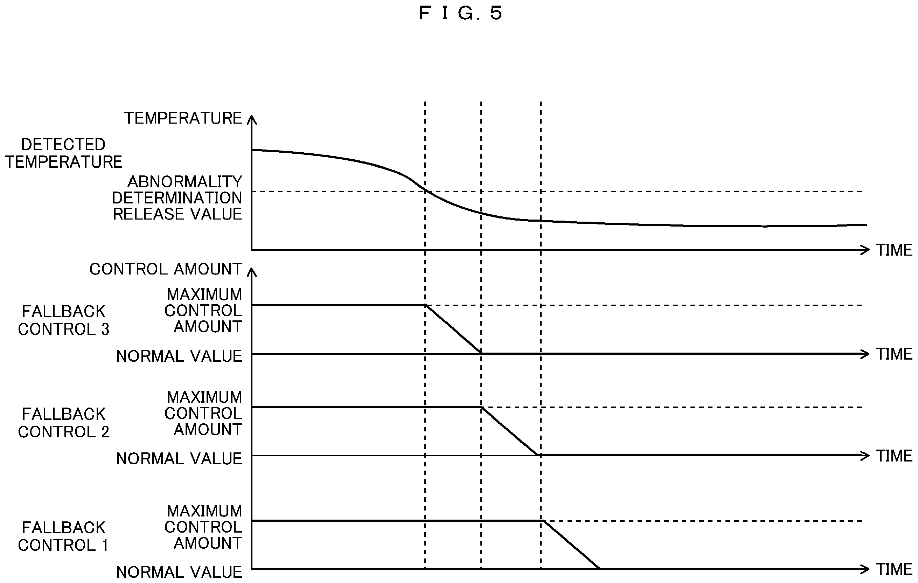

Fig. 5 is a time chart in a case in which the temperature detected by the temperature detecting unit 107 exceeds the temperature abnormality determination value, and in a state in which the fallback control 1, the fallback control 2, and the fallback control 3 are executed at the same time, the temperature detected by the temperature detecting unit 107 falls below an abnormality determination release value, and the temperature abnormality is released. In Fig. 5, if the temperature falls below the abnormality determination release value, the fallback control unit 112 causes the control amount of the element A in the fallback control 3 to decrease from the maximum value in accordance with the temperature. When the control amount of the element A returns to the normal value, and the fallback control 3 is released, the fallback control unit 112 causes the control amount of the element B in the fallback control 2 to decrease from the maximum value in accordance with the temperature. When the control amount of the element B returns to the normal time, the fallback control unit 112 causes the control amount of the element C in the fallback control 1 to decrease from the maximum value in accordance with the temperature.

As another example of the temperature control element, there is, for example, control of an electric current or a voltage to be output to the AC motor 105. In a case in which the output current is set as the temperature control element, the fallback control unit 112 starts to decrease an output current value limited to, for example, 15 A and cause the output current value up to 10 A which is a maximum limit value at which torque can be restricted until the temperature abnormality is released. Further, in a case in which the output voltage is set as the temperature control element, the fallback control unit 112 starts to decrease the output voltage value controlled to, for example, 50 V and cause the output voltage value up to 30 V which is a maximum limit value at which torque can be restricted until the temperature abnormality is released.

As described above, according to the present embodiment, provided is a temperature reduction method of an electric power conversion device including setting a priority for performing fallback control on a plurality of temperature control elements, executing the fallback control on a temperature control element having a highest priority in accordance with the set priority when a temperature of the electric power conversion device is higher than a temperature abnormality determination value, and executing the fallback control on a temperature control element having a second highest priority while holding a control amount of the temperature control element having the highest priority to a maximum value when the control amount of the control element reaches a maximum value.

Further, provided is an electric power conversion device including a forward converter that converts an alternating current (AC) power of an AC power source into a direct current (DC) power, a DC smoothing circuit that smooths the DC power, an inverse converter that inversely converts the smoothed DC power into an AC power, a cooling unit that cools the inverse converter, a control unit that outputs a PWM command to the inverse converter and outputs a drive voltage to the cooling unit, a temperature detecting unit that detects a temperature of the electric power conversion device, a fallback control unit that performs fallback control on a plurality of temperature control elements, and a manipulating unit that sets a priority for performing the fallback control on the plurality of temperature control elements, in which the fallback control unit executes the fallback control on a temperature control element having a highest priority in accordance with the set priority when the temperature detecting unit detects an abnormality in a temperature, and executes the fallback control on a temperature control element having a second highest priority while holding a control amount of the temperature control element having the highest priority to a maximum value when the control amount of the control element reaches a maximum value.

Accordingly, since the temperature control element which affects the loss is effectively controlled, it is possible to provide a method of sustaining the function of the user system as much as possible.

### Second embodiment

In the present embodiment, the description will proceed with a setting of the temperature control element of the electric power conversion device according to the present embodiment.

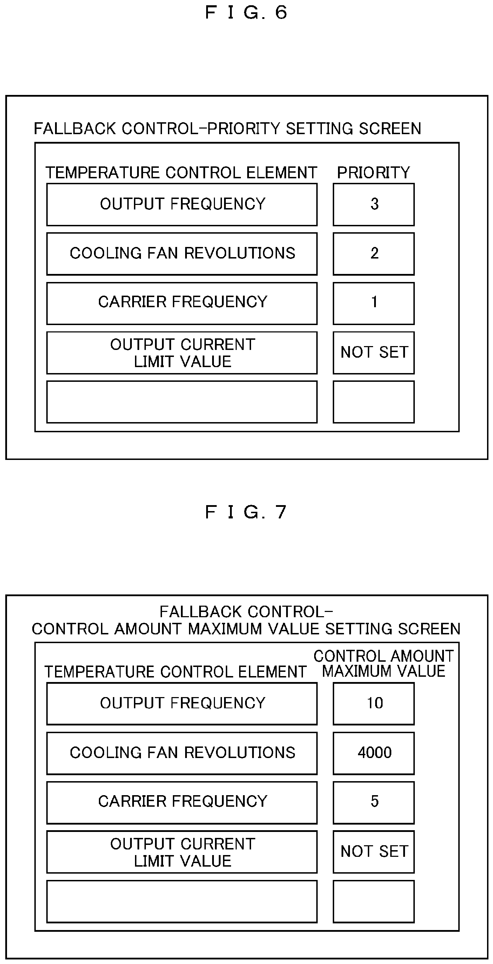

Fig. 6 is a diagram illustrating a priority setting screen of the fallback control of the temperature control element in the manipulating unit of the electric power conversion device. For example, the manipulating unit of the electric power conversion device is a touch input type display panel, and it is possible to input and perform various kinds of settings to the electric power conversion device. Fig. 6 illustrates a screen of setting function to be displayed. In Fig. 6, in the present embodiment, when the temperature abnormality is detected, the priority of the fallback control is set for various temperature control elements. In the present embodiment, the carrier frequency, the cooling fan revolutions, the output frequency, the limit value of the output current value will be described as an example of the temperature control element.

As illustrated in Fig. 6, the falling control priority setting screen includes an item input screen for the temperature control element and an input setting screen for the priority of the fallback control. Further, the priority of the fallback control is set for various temperature control elements by setting an item or a setting value in the input screens. In the case of the temperature control element on which the fallback is not performed such as the output current limit value illustrated in Fig. 6, it is considered that there is no priority setting, and thus a setting in which the fallback control is not performed may be performed.

The inputs may be selected in a pull-down manner. Further, the inputs are set by the user but may be set by default in advance.

Fig. 7 is a diagram illustrating a fallback control-control amount maximum value setting screen as a temperature control element setting in the manipulating unit of the electric power conversion device. In Fig. 7, in the present embodiment, the maximum value of the control amount of the fallback control is set when the temperature abnormality is detected.

As illustrated in Fig. 7, the fallback control-control amount maximum value setting screen includes a temperature control element item input screen and a control amount maximum value input setting screen. The control amount maximum value of the fallback control is set for various temperature control elements by setting an item or a setting value in the input screens. As the control amount maximum value, an absolute value thereof may be input, or a control amount change range may be set.

The inputs may be selected in a pull-down manner. Further, the inputs are set by the user but may be set by default in advance.

As described above, according to the present embodiment, provided is an electric power conversion device including a forward converter that converts an alternating current (AC) power of an AC power source into a direct current (DC) power, a DC smoothing circuit that smooths the DC power, an inverse converter that inversely converts the smoothed DC power into an AC power, a cooling unit that cools the inverse converter, a control unit that outputs a PWM command to the inverse converter and outputs a drive voltage to the cooling unit, a temperature detecting unit that detects a temperature of the electric power conversion device, and a manipulating unit that is capable of inputting and setting various kinds of settings to the electric power conversion device, in which the manipulating unit includes an item input screen for a temperature control element and an input setting screen for a priority of fallback control of the temperature control element.

Further, the manipulating unit is configured to have an input setting screen for the control amount maximum value of the temperature control element.

Accordingly, it is possible to effectively control the temperature control element which affects the loss.

### Third embodiment

In the present embodiment, the description will proceed with an error protection selection setting screen when the electric power conversion device according to the present embodiment has the temperature abnormality.

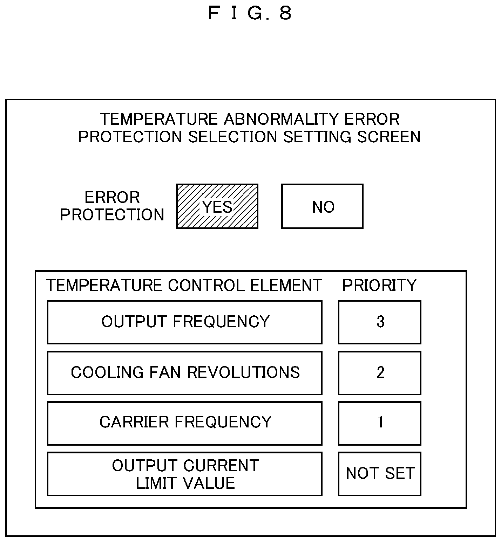

Fig. 8 illustrates a screen that enables the user to set whether to cause the electric power conversion device 100 to continue the operation as long as possible in a state in which the control amounts of all the temperature control elements are held to the maximum value or to output an error as a temperature control range abnormality and perform the protection operation in order to prevent the damages of the electric power conversion device when the control amount of the fallback control becomes the maximum value.

As illustrated in Fig. 8, in the temperature abnormality error protection selection setting screen, a screen in which it is selected whether or not the error protection is performed is provided. It is possible to set the error protection at the time of temperature abnormality by choosing the error protection from the screens. Fig. 8 illustrates a state in which the case in which the error protection is selected, and a color of a selected item is changed, but any display can be used as long as the selection setting state can be distinguished. Further, in Fig. 8, under the screen in which it is selected whether or not the error protection is performed, the temperature control element and the priority of the current fallback control may be displayed, and a condition material for determining the error protection setting at the time of temperature abnormality may be presented.

The present invention is not limited to the above-described embodiments and includes various modified examples. For example, the above embodiments have been described to facilitate understanding of the present invention, and the present invention is not limited to a configuration necessarily including all components described above. A component of a certain embodiment may be replaced with a component of another embodiment, or a configuration of another embodiment may be added to a configuration of a certain embodiment. Further, some of the components of each embodiment can be added, deleted, or replaced with other components of another embodiment.

Furthermore, some or all of components, functions, processing units, processing devices, or the like described above may be implemented by hardware, for example, may be designed by an integrated circuit. Further, components, functions, and the like described above may be implemented by software by interpreting and executing a program for implementing the functions through a processor. Information such as a program, a table, a file, or the like of implementing each function may be stored in a recording device such as a memory, a hard disk, or a solid state drive (SSD) or a recording medium such as an IC card, an SD card, or a DVD.

Furthermore, in the above-described embodiment, a control line or an information line are illustrated since they are necessary for description, and all control lines or information lines necessary in a product are not necessarily illustrated. Practically, almost all the components may be connected to one another.

### REFERENCE SIGNS LIST

- 100: electric power conversion device
- 101: three-phase AC power source
- 102: DC converting unit
- 103: DC smoothing unit
- 104: AC converting unit
- 105: AC motor
- 106: electric current detector
- 107: temperature sensing unit
- 108: cooling fan
- 111: control unit
- 112: fallback control unit
- 113: manipulating unit

## Claims

1. A temperature reduction method of an electric power conversion device, comprising:
setting a priority for performing fallback control on a plurality of temperature control elements;
executing the fallback control on a temperature control element having a highest priority in accordance with the set priority when a temperature of the electric power conversion device is higher than a temperature abnormality determination value; and
executing the fallback control on a temperature control element having a second highest priority while holding a control amount of the control element having the highest priority to a maximum value when the control amount of the temperature control element reaches a maximum value.

2. The temperature reduction method of the electric power conversion device according to claim 1,
wherein the maximum values of the control amounts of the plurality of temperature control elements are settable by a user.

3. The temperature reduction method of the electric power conversion device according to claim 2,
wherein the maximum values of the control amounts of the plurality of temperature control elements are change range setting values of the control amounts of the plurality of temperature control elements or change range maximum values of the control amounts of the plurality of temperature control elements.

4. The temperature reduction method of the electric power conversion device according to claim 1,
wherein the priority of the temperature control element in which the fallback control is performed is settable by a user.

5. The temperature reduction method of the electric power conversion device according to claim 1,
wherein it is possible to select and set whether error protection is performed or an operation is continued when the fallback control is performed on the plurality of temperature control elements up to the maximum value.

6. An electric power conversion device, comprising:
a forward converter that converts an alternating current (AC) power of an AC power source into a direct current (DC) power;
a DC smoothing circuit that smooths the DC power;
an inverse converter that inversely converts the smoothed DC power into an AC power;
a cooling unit that cools the inverse converter;
a control unit that outputs a PWM command to the inverse converter and outputs a drive voltage to the cooling unit;
a temperature detecting unit that detects a temperature of the electric power conversion device;
a fallback control unit that performs fallback control on a plurality of temperature control elements; and
a manipulating unit that sets a priority for performing the fallback control on the plurality of temperature control elements,
wherein the fallback control unit executes the fallback control on a temperature control element having a highest priority in accordance with the set priority when the temperature detecting unit detects an abnormality in a temperature, and executes the fallback control on a temperature control element having a second highest priority while holding a control amount of the control element having the highest priority to a maximum value when the control amount of the temperature control element reaches a maximum value.

7. The electric power conversion device according to claim 6,
wherein the maximum values of the control amounts of the plurality of temperature control elements are settable through the manipulating unit.

8. The electric power conversion device according to claim 7,
wherein the maximum values of the control amounts of the plurality of temperature control elements are change range setting values of the control amounts of the plurality of temperature control elements or change range maximum values of the control amounts of the plurality of temperature control elements.

9. The electric power conversion device according to claim 6,
wherein it is possible to select and set whether error protection is performed or an operation is continued when the fallback control is performed on the plurality of temperature control elements up to the maximum value through the manipulating unit.

10. An electric power conversion device, comprising:
a forward converter that converts an alternating current (AC) power of an AC power source into a direct current (DC) power;
a DC smoothing circuit that smooths the DC power;
an inverse converter that inversely converts the smoothed DC power into an AC power;
a cooling unit that cools the inverse converter;
a control unit that outputs a PWM command to the inverse converter and outputs a drive voltage to the cooling unit;
a temperature detecting unit that detects a temperature of the electric power conversion device; and
a manipulating unit that is capable of inputting and setting various kinds of settings to the electric power conversion device,
wherein the manipulating unit includes an item input screen for a temperature control element and an input setting screen for a priority of fallback control of the temperature control element.

11. The electric power conversion device according to claim 10,
wherein the manipulating unit includes an input setting screen for a control amount maximum value of the temperature control element.

12. The electric power conversion device according to claim 10,
wherein the manipulating unit includes an input setting screen for whether or not error protection is performed at a time of temperature abnormality.
